# EUROPEAN PATENT APPLICATION

(11) **EP 2 248 921 A1**
(43) Date of publication of application: **10.11.2010**
(21) Application number: 09706552.8
(22) Date of filing: 30.01.2009
(51) Int. Cl.: C22C 9/06, C22C 9/04, C22F 1/08, H01B 1/02, H01B 13/00, C22F 1/00

(54) **COPPER ALLOY MATERIAL FOR ELECTRIC/ELECTRONIC COMPONENT AND METHOD FOR MANUFACTURING THE COPPER ALLOY MATERIAL**

(30) Priority: 31.01.2008 JP 2008022088
(71) Applicant: The Furukawa Electric Co., Ltd., Chiyoda-ku Tokyo 100-8322 (JP)
(72) Inventor: MIHARA, Kuniteru, Tokyo 100-8322 (JP); MATSUO, Ryosuke, Tokyo 100-8322 (JP); EGUCHI, Tatsuhiko, Tokyo 100-8322 (JP)
(74) Representative: Forstmeyer, Dietmar
(86) International application number: PCT/JP2009/051623
(87) International publication number: WO 2009/096546

(57) **Abstract**

An copper alloy material for electric/electronic components containing Co by 0.2 to 2 mass% and Si by 0.05 to 0.5 mass% and having a remaining component composed of Cu and unavoidable impurities,
**characterized in that** its grain size is 3 to 35 µm and size of precipitate containing the both of Co and Si is 5 to 50 nm, electric conductivity is 50 % IACS or more, tensile strength is 500 MPa or more and bending workability (R/t) is 2 or less.

## Description

### TECHNICAL FIELD

The present invention relates to a copper alloy material, and a method for manufacturing the same, applied to electric/electronic components such as a connector, a terminal material and the like of electric/electronic apparatus or more specifically to a high-frequency relay and a switch desired to have high conductivity or to a connector, a terminal material, a lead frame and the like mounted in cars.

### BACKGROUND ART

So far, brass (C2600) and phosphor bronze (C5191, C5212, C5210) as well as beryllium copper (C17200, C17530) and Corson alloy (C7025) and others are used for connectors, terminals, relays, switches and others of electric/electronic apparatus.
Lately, frequency of electric current used in the electric/electronic apparatus using those parts is increased and substantial electric conductivity drops due to a skin effect, so that materials are also required to have a high conductivity. While the electric conductivity of brass and phosphor bronze are low from the beginning and Corson copper alloy shows medium conductivity (EC nearly equal 40 to 50 % IACS) as a connecter member, higher conductivity is required. Although beryllium copper has the medium conductivity, it is expensive. Still more, because beryllium is an environmental burdening material, it is known to be considered to replace to other copper alloy and the like. Meanwhile, pure copper (C1100), tinned copper (C14410) and the like, which have high conductivity, have a drawback that their strength is low. Then, it is desired to have a copper alloy having conductivity exceeding the prior art Corson copper, equivalent tensile strength and bending workability.
The numbers in parentheses (CXXXX) denote types of copper alloys specified by the JIS, and % IACS is an abbreviation of the International Annealed Copper Standard and is unit indicating copper alloy of materials.

In general, conductivity and strength are conflicting properties. While there are various methods for strengthening such as solid-solution strengthening, processing strengthening, precipitation strengthening and the like, it is known that among them, the precipitation strengthening is a promising method for enhancing the strength of the copper alloy without deteriorating the copper alloy. This precipitate strengthening is a method of treating an alloy into which element causing precipitation is doped at high temperature to solid-solution such element in the copper mother phase and of then treating at temperature lower than such temperature to precipitate the solid-solution element. This strengthening method is adopted for beryllium copper, Corson alloy and others for example.

By the way, there are known alloys containing intermetallic compounds of cobalt (Co) and silicon (Si) within copper, besides beryllium copper, Corson alloy and others described above. In the technology of the copper base alloy, using the intermetallic compound of Co and Si, there is some conventional example.
Their known examples include a copper alloy containing Co, Si, Zn, Mg and S as essential components (see Patent Document 1 for example) and an alloy containing Co, Si, Mg, Sn and Zn (see Patent Document 2 for example), a copper alloy essentially containing Co, Si, Sn and Zn (see Patent Document 3 for example). Patent Documents 2 and 3 describe as Co₂Si compound as for the precipitate of Co and Si. There is a document that describes a Cu-Co-Si group alloy as a copper alloy for the use of a lead frame (see Patent Document 4 for example).

Patent Document 1: Japanese Patent Application Laid-open No. Sho. 61-87838
Patent Document 2: Japanese Patent Application Laid-open No. Sho. 63-307232
Patent Document 3: Japanese Patent Application Laid-open No. Hei. 02-129326
Patent Document 4: Japanese Patent Application Laid-open No. Hei. 02-277735

### DISCLOSURE OF INVENTION

### Problems to be Solved by the Invention

By the way, Patent Document 1 aims at improving hot workability, describes nothing about the precipitate of Co and Si and naturally describes nothing about how to control its size and others. Still more, it describes no evaluation results of its strength and copper alloy in the embodiment. Further, types of alloys are different because S is essential.
Although Patent Document 2 describes about the precipitate of Co and Si as the Co₂Si compound, it describes nothing about its size and its control method and leaves them unknown. Patent Document 2 carries out only annealing of one hour at 500°C or 450°C and carries out no recrystallization treatment. That is, because it is a forced rolled material, its grain size is unclear.
Although Patent Document 3 describes about the precipitate of Co and Si as the Co₂Si compound similarly to Patent Document 2, its size and its control method are unknown in the same manner with Patent Document 2 and it carries out annealing for one hour at 400 to 500°C. Still more, Patent Document 3 carries out a solution treatment at 950°C and cold rolling before the annealing. Because Patent Document 3 describes a high additive amount of Sn of 1 mass%, it shows a relatively low copper alloy of 30 % IACS or less in its embodiment.
While Patent Document 4 describes a copper alloy for the use of a lead frame and describes as a precipitate strengthening type alloy, it does not disclose its specific compound or its size. Patent Document 4 also carries out a heat treatment of one hour at 500°C and then only cold rolling and stress relieving annealing of one hour at 300°C and carries out no recrystallizing treatment. Therefore, the grain size is assumed to be unclear.

It is an ordinary case for a material applied to connectors, relays, switches and others involving a bending work that if it is highly worked after a recrystallizing treatment in its fabrication process, its bending workability deteriorates due to an influence of working strain. While a recrstallizing heat treatment must be carried out in high temperature, no high temperature heat treatment process that cause recrystallization is added at all after the hot rolling in the embodiments of the Patent Documents 1, 2 and 4, so that it is judged that bending workability of the forced rolled material is inferior.
Meanwhile, it is also known that the bending workability is inferior if grain size is coarse in composition of an alloy. However, solution temperature of Patent Document 3 is so high as 950°C and the higher the temperature, the coarser the grain size is, so that it is judged that the bending workability of this material is also inferior. Still more, 950°C is close to a fusion point of copper alloy, so that the shape of the material is not stabilized. Still more, because a special material has to be used for a fire-resistant material of a furnace of the heat treatment when the temperature is high, it is disadvantageous condition industrially.

### Means for Solving the Problems

Thus, it was found that it is unable to obtain a desirable material just by the known technologies as disclosed in the respective Patent Documents described above to develop a copper alloy having a high conductivity, high strength and favorable bending workability. Still more, it was found that it is important to adequately control grain size in order to obtain a material having the favorable bending workability.
Then, in view of the problems described above, the present invention aims at providing a copper alloy material, and its fabrication method, that excels in the three points of the high copper alloy, high strength and bending workability and suitable for electric/electronic components such as connectors, terminal materials, relays and others.

The inventor et al. studied a copper alloy suitable for the use of the electric/electronic components and found that it is important to meet characteristics of 50 % IACS or more of conductivity, 500 MPa or more of tensile strength and R/t ≤ 2 of bending workability in the same time.
Here, R in R/t is a bending radius and t is a plate thickness. It indicates that the lower the value, the better the bending workability is.
Then, in order to achieve the high conductivity, high strength and favorable bending workability, the inventor et al. obtained specific component compositions, defined grain size, found the optimum relationship with size of precipitate and consummated the invention by reviewing the study.

The invention provides the following means:
(1) An copper alloy material for electric/electronic components containing Co by 0.2 to 2 mass% and Si by 0.05 to 0.5 mass% and having a remaining component composed of Cu and unavoidable impurities,
   **characterized in that** its grain size is 3 to 35 µm and size of precipitate containing the both of Co and Si is 5 to 50 nm.
(2) The copper alloy material for electric/electronic components as described in the aspect (1), **characterized in that** the alloy material further contains 0.01 to 0.5 mass% of one or two or more types selected from a group of Fe, Ni, Cr and P.
(3) The copper alloy material for electric/electronic components as described in the aspect (1), **characterized in that** the alloy material further contains 0.01 to 0.5 mass% of one or two or more types selected from a group of Sn, Zn, Mg and Mn.
(4) The copper alloy material for electric/electronic components as described in the aspect (2), **characterized in that** the alloy material further contains 0.01 to 0.5 mass% of one or two or more types selected from a group of Sn, Zn, Mg and Mn.
(5) The copper alloy material for electric/electronic components as described in any one of the aspects (1) through (4), **characterized in that** electric conductivity is 50 % IACS or more, tensile strength is 500 MPa or more and bending workability (R/t) is 2 or less.
(6) A method for manufacturing an copper alloy material for electric/electronic components to obtain a copper alloy material whose grain size is 3 to 35 µm and whose size of precipitate containing the both of Co and Si is 5 to 50 nm, **characterized in that** the method comprises:
   a step-A of carrying out a solution recrystallizing heat treatment of a copper alloy containing Co by 0.2 to 2 mass% and Si by 0.05 to 0.5 mass% and having a remaining component composed of Cu and unavoidable impurities in temperature not less than 700°C and less than 950°C; and
   a step-B of carrying out a cooling process, after the previous step-A, with an average cooling speed of 50°C /sec or more from the temperature during the solution recrystallizing heat treatment to 300°C.
It is noted that the "high conductivity" here means that electric conductivity is 50 % IACS or more.

### ADVANTAGEOUS EFFECTS OF THE INVENTION

The invention permits to obtain the copper alloy material that has the three characteristics of the high copper alloy, high strength and excellent bending workability and is suitable for parts of the electric/electronic apparatus by limiting the grain size and controlling the minute size of the precipitate of the alloy having the specific composition of Cu-Co-Si. Still more, the copper alloy material having the more excellent characteristics may be obtained by adding Fe, Ni, Cr and P as well as Sn, Zn, Mg and Mn as alloy components.
Still more, it is possible to control the grain size and the size of the precipitate and to obtain the copper alloy material having the excellent characteristics by carrying out the solution recrystallizing heat treatment in specific temperature and by limiting its cooling speed.
The above and other features and advantages of the invention will be more apparent from the description below by appropriately making reference to the appended drawing.

### BRIEF DESCRIPTION OF DRAWING

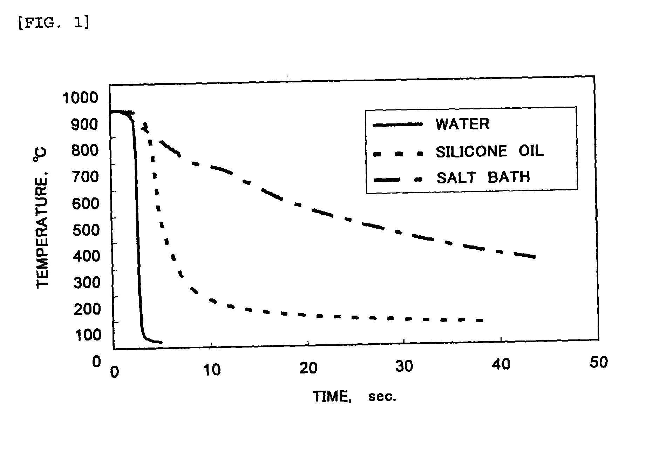

[FIG. 1] FIG. 1 is a graph showing one exemplary cooling speed of various cooling solutions.

### BEST MODE FOR CARRYING OUT THE INVENTION

A preferable mode of an alloy composition of a copper alloy material of the present invention will be explained in detail below. It is noted that the copper alloy material of the invention is a copper alloy material having a specific shape such as a plate, strip, wire, rod, foil and the like and may be used for any kinds of electric/electronic components. Although the parts are not specifically limited, the copper alloy material may be suitably used for connector, terminal materials and the like, high-frequency relays and switches desired to high conductivity in particular, or connectors, terminal materials and lead frames mounted in cars.
Co and Si are essential components in the composition of the copper alloy of the invention. Co and Si within the copper alloy mainly form the precipitate of Co₂Si intermetallic compound to improve strength and electric conductivity.
An amount of Co is 0.2 to 2 mass%, or preferable to be 0.5 to 1.5 mass% or more preferable to be 0.8 to 1.4 mass%. An amount of Si is 0.05 to 0.5 mass%, or preferable to be 0.1 to 0.45 mass% or more preferable to be 0.18 to 0.35 mass%. The reason why their amounts are specified as such is because they form the precipitate of intermetallic compound of Co₂Si and contribute for precipitate strengthening. If the amount of Co is too little, the precipitate strengthening amount is small and the amount is excessive, its effect is saturated. Further, while the optimum additive ratio from stoichiometric proportion of compounds is Co/Si ≒ 4.2, it is preferable to modify Co/Si so that the value falls within a range from 3.0 to 6.0 or more preferable to be 3.8 to 4.6 centering on that value described above.
Further, there is a preferable range in a relationship between the additive amount of Co and the temperature at which the solution recrystallizing heat treatment is carried out. For instance, when the additive amount of Co is 0.2 to 0.8 mass%, the temperature at which the solution recrystallizing heat treatment is carried out is preferable to be in a range of 700 to 800°C, when the additive amount of Co is 0.5 to 1.2 mass%, the temperature at which the solution recrystallizing heat treatment is carried out is preferable to be in a range of 800 to 900°C and when the additive amount of Co is 1.0 to 2.0 mass%, the temperature at which the solution recrystallizing heat treatment is carried out is preferable to be in a range of 900 to 950°C. The temperature at which the solution recrystallizing heat treatment is carried out is not limited to the abovementioned temperature ranges as a matter of course, the abovementioned temperature ranges are desirable ranges based on the grain size described later.

It is also preferable to add either one or two or more types of Fe, Ni, Cr and P to the copper alloy of the invention and its amount is 0.01 to 0.5 mass% or preferably 0.2 to 0.4 mass%. These elements function to improve the strength by replacing with part of main precipitated phase of Co and forming the (Co, χ)₂Si compound (χ = Fe, Ni, Cr, P) ('The precipitate containing the both of Co and Si' includes 'precipitate containing Co and Si as well as one or two or more elements among Fe, Ni, Cr and P' besides 'precipitate containing Co and Si'). If the additive amount is too little, the effect of the addition is small and if it is too much in contrary, the element(s) hampers the conductivity by solid-solutioning into the copper mother phase and forming other compounds (noncoherent precipitate) having no strengthening action.

Still more, it is preferable to add either one or two or more types of Sn, Zn, Mg and Mn to the copper alloy of the invention and its amount is 0.01 to 0.5 mass% or preferably 0.08 to 0.3 mass%. These elements have an action of strengthening the copper alloy by solid-solutioning to the copper mother phase. Due to that, they are not effective if their amount is too little and they hamper the conductivity if their amount is too much. Therefore, it is preferable to keep them in this amount. It is noted that Zn has an effect of improving soldering adhesion and Mg and Mn has an effect of hot workability.
Fe, Ni, Cr and P and Sn, Zn, Mg and Mn will not hamper the respective characteristics even if they are added in complex if their amount is within the limited range.

The invention specifies the grain size and the size of the precipitate containing the both of Co and Si strictly to suitably realize the characteristics of the copper alloy material composed as described above. In the invention, the grain size is 3 to 35 µm or preferably 5 to 20 µm. The reason for that is because if the grain size is too small, duplex grain size containing parts fully recrystallized and unrecrystallized parts not fully recrystallized is prone to be generated and bending workability drops. If the grain size is too large on the other hand, grain boundary density is low because the grain diameter is coarse, so that it is assumed that the workability drops because it is unable to fully absorb bending stress. It is noted that the 'grain size' is a value measured based on the JIS-H0501 (cutting method) described later. Still more, the size of the precipitate of the compound mainly containing the both of Co and Si is set to be 5 to 50 nm in the copper alloy material of the invention. This compound enhances by precipitating coherently with the copper mother phase. The size is limited in this range because it is unable to obtain an enough precipitate strengthening amount if the size is too small and it loses the coherence and drops the strength in contrary if the size is too large. The desirable size of the precipitate is 10 to 30 nm.
The 'size of the precipitate' here is an average size of the precipitate found by a method described later.

The copper alloy material for electric/electronic components of the invention is preferable to have characteristics of 50 % IACS or more of electric conductivity, 500 MPa or more of tensile strength and 2 or less of bending workability (R/t). The reason of that is based on the necessity of meeting with the required minimum conductivity, tensile strength and bending workability for electric/electronic components demanded by the market in pursuit of downsized and high-performance electric/electronic apparatus. The more preferable electric conductivity is 55 % IACS or more or more preferable to be 60 % IACS or more. Even though it is preferable to be higher, its upper limit is normally around 70 % IACS. The more preferable tensile strength is 550 MPa or more or more preferable to be 600 MPa or more. Even though it is preferable to be higher, its upper limit is normally around 850 MPa. The more preferable bending workability (R/t) is 1.5 or less or more preferable to be 1 or less. Even though it is preferable to be smaller, its lower limit is zero practically.

Next, a preferable method for producing the copper alloy material of the invention is implemented in the following mode. An outline of the main fabrication process of the copper alloy material of the invention is dissolution, casting, hot rolling, facing, cold rolling, solution recrystallizing heat treatment, rapid quenching, aging heat treatment, final cold rolling and low-temperature annealing. The order of the aging heat treatment and the final cold rolling may be reversed. The final low-temperature annealing may be also cut.
In the invention, it is preferable to carry out the solution recrystallizing heat treatment before the final cold rolling in a range not less than 700°C and less than 950°C. The reason why the temperature range is thus specified is because it is necessary to be 700°C or more to fully solution-treat and recrystallize the element such as Co described above. The temperature is not also preferable industrially to be 950°C or more because it is close to the fusion of copper and causes such problems that the material may partially melt and the shape may be deformed. The solution treatment and the recrystallizing treatment may be fully carried out and the fabrication may be stably carried out industrially if the temperature is more than 800°C and less than 950°C. The grain size in the copper alloy material is decided by the recrystallization solution heat-treatment of this temperature.

Further, the rapid quenching of 50°C /sec or more of cooling speed from the solution recrystallizing heat treatment temperature is preferable in the invention. If the rapid quenching is not achieved, the solution-treated element in the high temperature described above may precipitate. The particles (compound) precipitated during this cooling is noncoherent precipitate not contributing to the strength and may give an adverse effect to the characteristics by contributing as a nucleus generating site in forming coherent precipitate in the next aging heat treatment step and by promoting precipitation of that part.
The cooling speed is preferable to be 80°C /sec or more and more preferable to be 100°C /sec or more. Even though faster quenching speed is desirable, its practical upper limit is normally 200°C /sec.
It is noted that this cooling speed means an average speed from the solution recrystallizing heat treatment temperature to 300°C. Because no large change of structure occurs in the temperature under 300°C, it is just necessary to appropriately control the cooling speed to this temperature.
It is preferable to carry out the aging heat treatment after the solution recrystallizing heat treatment or after the final cold rolling after that in the invention. Preferably, the aging heat treatment is carried out from 450°C to 600°C or more preferably from 500°C to 575°C. It is also preferable to carry out the aging heat treatment for one to four hours or more preferably for two to three hours.
It is more preferable to carry out the aging heat treatment from 525°C to 575°C in carrying out the aging heat treatment before the final cold rolling.
It is preferable to carry out the aging heat treatment from 450°C to 575°C or more preferably from 475°C to 525°C in carrying out the aging heat treatment after the final cold rolling. It is because a precipitation temperature zone shifts to the low-temperature side by the cold rolling process.
A processing rate in the final cold rolling (i.e., (H - H₁) ÷ H x 100: where H denotes a plate thickness before the final cold rolling and H₁ denotes a plate thickness after the final cold rolling) is preferable to be 5 to 25 % or more preferable to e 5 to 10 %.
Although the low-temperature annealing (strain relieving annealing) may be carried out by the ordinary method, it is preferable to carry out from 300°C to 450°C or more preferably from 350°C to 400°C and for 5 to 120 seconds or more preferably for 10 to 30 seconds.

### EMBODIMENTS

Next, while the invention will be explained in more detail based on embodiments thereof, the invention is not limited to them.

### (First Embodiment)

The copper alloy used in the embodiment of the invention and in comparative examples are alloys containing the components shown in Tables 1 and 2 and having the remaining parts composed of Cu and the unavoidable impurities (Examples of the invention Nos. 1 through 30) and comparative examples Nos. 1 through 20). The respective alloys are melted in a high-frequency melting furnace and are casted with 10 to 30°C /sec of cooling speed to obtain ingot of 30 mm thick, 100 mm width and 150 mm long.
The ingot thus obtained was held for 0.5 to 1.0 hour in 930°C to 970°C. After that, hot rolling was carried out to fabricate a hot rolled plate having a thickness t = 12 mm. The both faces thereof were faced by 1 mm each so as to be t = 10 mm. Next, it is finished to be t = 0.3 mm by cold rolling and the solution recrystallizing heat treatment was carried out in temperature from 700°C to 950°C. The final copper alloy material was prepared by implementing either one of the following two steps on the material treated by the solution recrystallizing heat treatment
Step-A: solution recrystallizing heat treatment → rapid quenching → aging heat treatment (for 0.5 to 6 hours in temperature from 500 to 600°C) → final cold rolling (5 to 25 % of processing rate) → final copper alloy material
It is noted that the strain relieving annealing was implemented for one to two hours in temperature of 300 to 400°C after the final cold rolling to relieve the strain caused by the final cold rolling.
Step-B: solution recrystallizing heat treatment → rapid quenching →final cold rolling (5 to 25 % of processing rate) → aging heat treatment (for 0.5 to 5 hours in temperature from 450 to 550°C final copper alloy material
Tables 1 and 2 show the solution recrystallizing heat treatment temperatures, the cooling speeds in rapid quenching process, aging heat treatment temperatures, aging heat treatment times, processing rates of the final cold rolling adopted in the examples of the invention and in the comparative examples.

The following characteristic investigation was carried out on the samples of the final copper alloy material and their results were shown Table 1 (examples of the invention) and Table 2 (comparative examples).

### a. Grain Size:

The grain size was measured according to the cutting method in the JIS H0501 by mirror-finishing a section of the sample perpendicular to the rolling direction of the test piece by wet polishing and buffing, by fretting the polished surface for several seconds by a solution of chromic acid : water = 1 : 1 and by photographing by an optical microscope at 200 to 400-fold magnification or at 500 to 2000-fold magnification by using a secondary electronic image of a scanning electronic microscope (SEM).
It is noted that the "duplex grain" in Table means a structure in which the both of recrystallized grains and nonrecrystallized grains (residue of rolling) are mixed and the grain size was not measured in the case of the duplex grain size. It is said that bending workability is deteriorated if nonrecystallized grains exist. Therefore, the duplex grain size is an undesirable structure.

### b. Size of Precipitate:

The size of the precipitate was evaluated by using a transmission electron microscope. Because it becomes difficult to observe the final copper alloy material due to an influence of processing strain (in the case of the step-A in particular), the structure of the material after the aging heat treatment was observed. It is because the size and density of the precipitate do not change by the strain relieving annealing and the cold rolling and the size of the precipitate after the aging heat treatment coincides with the size of the precipitate of the final copper alloy material. A test piece for observation was completed by cutting out a test piece for the TEM from an arbitrary part of the material treated by the aging heat treatment and by carrying out electrolytic polishing (Twin Jet: manufactured by Storas Co.) by a methanol solution of nitric acid (20 %) in temperature from -20°C to -25°C.
After that, observation was carried out with 300 kV of acceleration voltage, incidence azimuth of an electron beam was adjusted to the vicinity of (001) and three pictures of 100,000-fold magnification were taken arbitrarily. The average size of the precipitate (about 100 pieces) was found by using those pictures.

### c. Tensile Strength:

Tensile strength of three test pieces of JIS Z2201-13B cut out in the rolling parallel direction of the respective samples was measured under conditions of 10 mm/min. of tensile speed and 50 mm of gauge length based on JIS Z2241 and their average value was found.

### d. Measurement of Electrical Conductivity:

The electric conductivity was measured for two test pieces of the respective samples within a constant-temperature bath controlled at 20°C (±1°C by using a four-terminal method and their average value (% IACS) was found. A distance between the terminals was 100 mm.

### e. Bending Workability:

The respective samples were cut perpendicularly in the rolling direction to be 10 mm in width and 35 mm long. They are then bent by 90° W bending (Bad-way bending) so that an axis of bending is paralleled with the rolling direction. It was then investigated whether or not any crack exists in the bent part by observing visually with 50-fold magnification by the optical microscope and by the scanning electron microscope (SEM). Eight levels of bending radius R were set (R = 0 to 0.5 mm: i.e., 0, 0.1, 0.15, 0.2, 0.25, 0.3, 0.4 and 0.5 mm).
It is noted that the evaluation result was represented by R/t (R: bending radius, t : plate thickness) and R/t was calculated by adopting R at the limit causing a crack. If no crack is generated when R = 0.15 (mm) and a crack is generated when R = 1 (mm) and when the thickness (t) = 0.15 mm, it was represented as R/t = 0.15/0.15 = 1.

In the embodiment, the adjustment of the cooling speed was carried out by changing the type and amount of the cooling solution in the bath for implementing quenching. Three cooling solutions of water (water temperature: 20 to 30°C), silicone oil (liquid temperature: 20 to 30°C) and salt bath (liquid temperature: 300°C, nitrate salt was used) were prepared. It is noted that in the case of the salt bath, water bath was also used for cooling (secondary cooling) less than 300°C to cool down to the normal temperature. FIG. 1 shows one exemplary cooling speed of the various cooling solutions. This data shows a result measured by attaching a thermocouple to the test pieces (50 x 150 x 0.2 mm).
An amount of all of the cooling solutions in this case was about five liters and the cooling speed was fast in an order of water > silicone oil > salt bath. It is noted that when the test was also carried out by changing the condition of the cooling solutions from the test described above, while the curve of the cooling speed became moderate when the amount of the cooling solution was reduced, the cooling speed was not improved remarkably even if the amount of the cooling solution was increased.

### [Table 1]

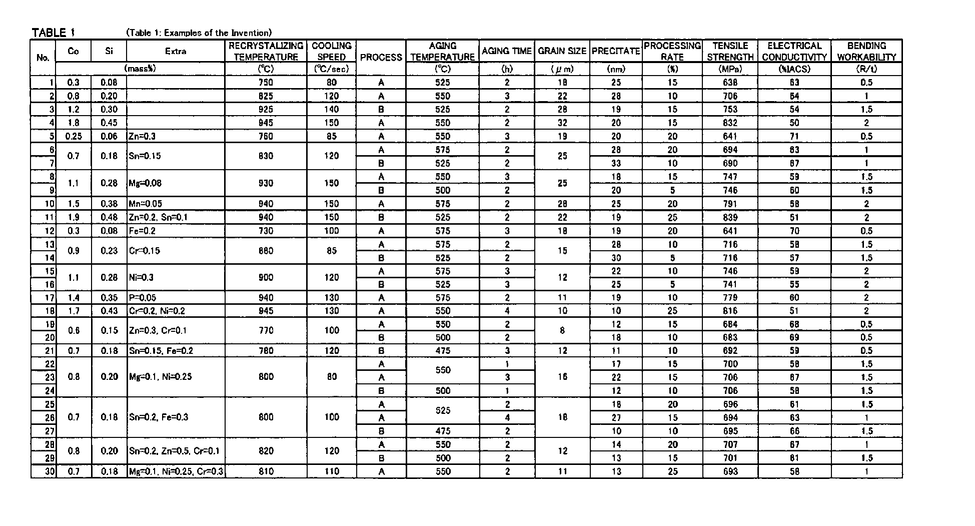

### [Table 2]

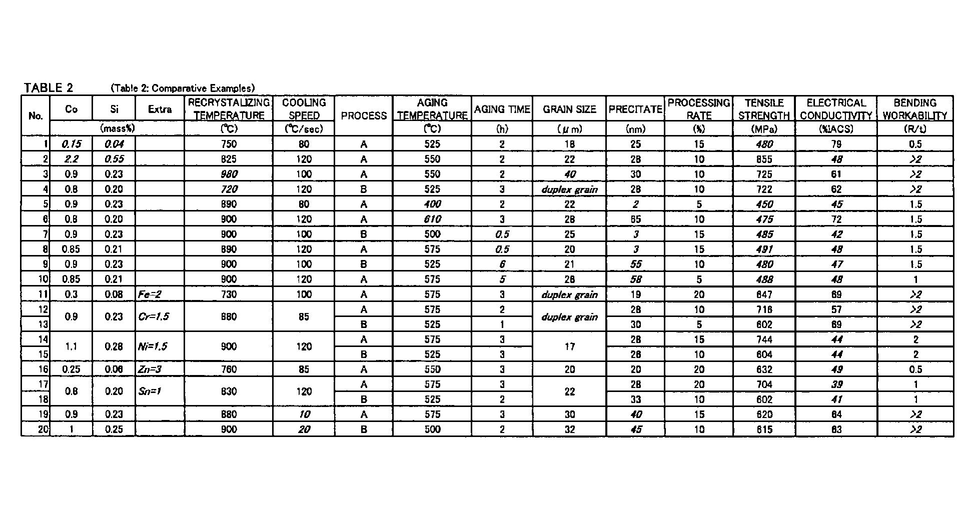

All of the copper alloy materials of Nos. 1 through 30 of the examples of the invention show high strength, high conductivity and favorable bending workability.
In contrary to that, Nos. 1 through 13 of the comparative examples include ones out of the range of the mode described above in the aspect (1) and do not satisfy at least one of the strength, conductivity and bending workability. Further, Nos. 11 through 15are comparative examples related to the mode described above in the aspect (2) and are out of the range of the composition specified in the aspect (2) and Nos. 16 through 18 are comparative examples related to the mode described above in the aspect (3), are out of the range of the composition specified in the aspect (3) and do not satisfy at least one of the strength, conductivity and bending workability.
Then, Nos. 19 and 20 are comparative examples related to the mode descried above in the aspect (5) and are out of the range of the mode specified in the aspect (5), so that they are inclined to be inferior in terms of tensile strength and bending workability as compared to the examples 1 through 4 of the invention (the examples 2 and 3 of the invention in particular) that are within the range of the mode described in the aspect (5).

While the invention has been explained with the embodiment thereof, the invention should not be limited to any detail of the explanation unless specially specified and should be construed widely without departing the spirit and scope of the invention specified in the appended claims.

This application claims the foreign priority benefit under Japanese Patent Application No. 2008-022088, filed on January 31, 2008 in the Japan Patent Office, the disclosure of which is herein incorporated by reference in its entirety.

## Claims

1. An copper alloy material for electric/electronic components containing Co by 0.2 to 2 mass% and Si by 0.05 to 0.5 mass% and having a remaining component composed of Cu and unavoidable impurities,
**characterized in that** its grain size is 3 to 35 µm and size of precipitate containing the both of Co and Si is 5 to 50 nm.

2. The copper alloy material for electric/electronic components as described in Claim 1, **characterized in that** the alloy material further contains 0.01 to 0.5 mass% of one or two or more types selected from a group of Fe, Ni, Cr and P.

3. The copper alloy material for electric/electronic components as described in Claim 1, **characterized in that** the alloy material further contains 0.01 to 0.5 mass% of one or two or more types selected from a group of Sn, Zn, Mg and Mn.

4. The copper alloy material for electric/electronic components as described in Claim 2, **characterized in that** the alloy material further contains 0.01 to 0.5 mass% of one or two or more types selected from a group of Sn, Zn, Mg and Mn.

5. The copper alloy material for electric/electronic components as described in any one of Claims 1 to 4, **characterized in that** electric conductivity is 50 % IACS or more, tensile strength is 500 MPa or more and bending workability (R/t) is 2 or less.

6. A method for producing an copper alloy material for electric/electronic components to obtain a copper alloy material whose grain size is 3 to 35 µm and whose size of precipitate containing the both of Co and Si is 5 to 50 nm, **characterized in that** the method comprises:
a step-A of carrying out a solution recrystallizing heat treatment of a copper alloy containing Co by 0.2 to 2 mass% and Si by 0.05 to 0.5 mass% and having a remaining component composed of Cu and unavoidable impurities in temperature not less than 700°C and less than 950°C; and
a step-B of carrying out a cooling process, after the previous step-A, with an average cooling speed of 50°C /sec or more from the temperature during the solution recrystallizing heat treatment to 300°C.
